# FASCICULE DE BREVET EUROPEEN

(11) **EP 4 120 272 B1**
(45) Date de publication et mention de la délivrance du brevet: **23.04.2025**
(21) Numéro de dépôt: 22182461.8
(22) Date de dépôt: 01.07.2022
(51) Int. Cl.: G11C 16/04, G11C 16/10, G11C 16/22, G11C 16/24, G11C 16/26

(54) **DISPOSITIF DE MÉMOIRE NON VOLATILE LISIBLE UNIQUEMENT UN NOMBRE DE FOIS PRÉDÉTERMINÉ**
NICHTFLÜCHTIGE SPEICHERVORRICHTUNG, DIE NUR EINE VORBESTIMMTE ANZAHL VON MALEN LESBAR IST
NON-VOLATILE MEMORY DEVICE ONLY READABLE FOR A PREDETERMINED NUMBER OF TIMES

(30) Priorité: 13.07.2021 FR 2107581
(43) Date de publication de la demande: 18.01.2023
(73) Titulaire: STMicroelectronics (Rousset) SAS, 13790 Rousset (FR); STMicroelectronics International N.V., 1118 BH Schiphol (NL)
(72) Inventeur: LA ROSA, Francesco, 13790 Rousset (FR); BILDGEN, Marco, 74420 Habère-Poche (FR)
(74) Mandataire: Casalonga

(56) Documents cités:
- FR-A1- 3 025 649
- FR-A1- 3 059 458

## Description

Des modes de mise en œuvre et de réalisation concernent les mémoires non volatiles, et en particulier les mémoires lisibles une seule fois ou un nombre de fois prédéfini.

FR3059458A1 décrit un dispositif compact de mémoire non volatile du type à piégeage de charges dans une interface diélectrique Chaque cellule-mémoire comprend un transistor d'état sélectionnable par un transistor de sélection vertical enterré dans un substrat et comportant une grille de sélection enterrée. Les colonnes de cellules-mémoires comportent des paires de cellules-mémoires jumelles, les deux transistors de sélection d'une paire de cellules-mémoires jumelles ayant une grille de sélection commune, les deux transistors d'état d'une paire de cellules-mémoires jumelles ayant une grille de commande commune. Le dispositif comprend en outre, pour chaque paire de cellules-mémoires jumelles une région diélectrique située entre la grille de commande et le substrat et chevauchant ladite grille de sélection commune de façon à former de part et d'autre de la grille de sélection les deux interfaces diélectriques de piégeage de charges respectivement dédiées aux deux cellules-mémoires jumelles.

Il existe un besoin de proposer une structure de mémoire non volatile capable de stocker une information de plusieurs bits d'une façon rendant difficile voire impossible la restitution de la valeur correcte de l'information stockée en utilisant une méthode de lecture classique de mémoire.

Il existe également un besoin de proposer une telle structure de mémoire ne pouvant être lue qu'une seule fois, ou à tout le moins qu'un nombre prédéfini de fois, de façon à empêcher par exemple de nombreuses lectures répétitives de la mémoire par un tiers mal intentionné dans le but d'utiliser la donnée stockée un nombre important de fois pour effectuer des actions frauduleuses.

Selon un aspect, il est proposé un dispositif de mémoire non volatile, comprenant un plan mémoire comportant au moins une zone mémoire incluant une matrice de cellules mémoires ayant deux rangées et N colonnes.

Chaque cellule-mémoire comprend un transistor d'état ayant une grille de commande et une grille flottante, sélectionnable par un transistor de sélection vertical enterré dans un substrat et comportant une grille de sélection enterrée.

Chaque colonne de cellules-mémoires inclut une paire de cellules-mémoires jumelles.

Deux cellules-mémoires sont dites jumelles lorsque les deux transistors de sélection de cette paire de cellules-mémoires ont une grille de sélection commune.

Le dispositif de mémoire comprend également des moyens de traitement configurés pour stocker dans la zone mémoire, une information comportant une succession de N bits.

Cette information de N bits, peut comporter une donnée utile à stocker de N bits, par exemple une clé, ou bien une donnée utile à stocker de M bits, avec M inférieur à N, et N-M bits factices (« dummy bits » en anglais) ayant par exemple une valeur prédéfinie.

Le stockage de ladite information est avantageusement effectué de sorte que, à l'exception du dernier bit de la succession,
- un bit courant de ladite succession de bits est stocké dans deux cellules-mémoires situées sur une même rangée et sur deux colonnes adjacentes, et
- un bit courant et le bit suivant sont respectivement stockés dans deux cellules jumelles.

Une telle structure à cellules jumelles combinée avec ce remplissage du type damier de la zone mémoire et un stockage redondant du bit courant dans deux cellules-mémoires, conduit à un stockage robuste de l'information et rend difficile la restitution de la valeur correcte des bits de l'information, en particulier avec une méthode classique de lecture de ces cellules-mémoires.

A cet égard, afin d'assurer une lecture correcte d'un bit, les moyens de traitement sont avantageusement configurés pour, afin de pouvoir lire un bit stocké dans une première cellule jumelle, remplacer au préalable le bit stocké dans la deuxième cellule-jumelle par un bit de référence ayant une valeur de référence choisie pour permettre une restitution correcte de la valeur du bit stocké dans la première cellule jumelle. Cette valeur de référence est par exemple la valeur logique 0 correspondant à un état programmé de la cellule-mémoire jumelle.

En effet puisque les deux cellules jumelles sont sélectionnées simultanément, il ne faut pas que la valeur du bit stocké dans la deuxième cellule jumelle « masque » éventuellement (par exemple si cette valeur est égale à 1) la valeur du bit stocké dans la première cellule jumelle.

Par ailleurs les moyens de traitement sont en outre avantageusement configurés pour lire séquentiellement les N bits de l'information et, pour chaque bit de la succession à l'exception du dernier, remplacer un bit courant déjà lu de ladite information par le bit de référence, avant de pouvoir lire le bit suivant de ladite succession.

Une telle lecture avec remplacement de chaque bit déjà lu par le bit de référence, avant de pouvoir lire le bit suivant de l'information, revient à « détruire » les bits au fur et à mesure de leur lecture, à l'exception du dernier, et rend donc impossible une nouvelle restitution de l'information stockée.

La zone mémoire et donc le dispositif de mémoire ne peut donc être lu qu'une seule fois pour ne délivrer l'information stockée qu'une seule fois.

Bien entendu, selon un mode de réalisation, il est possible que le dispositif de mémoire comprenne plusieurs zones mémoires destinées à contenir la même information de N bits, et les moyens de traitement sont alors configurés pour lire successivement les différentes zones mémoires.

Ainsi, avec ce mode de réalisation il devient possible de lire l'information stockée autant de fois qu'il y a de zones mémoires.

Ce nombre de zones mémoires dépend bien entendu de l'application envisagée pour l'utilisation du dispositif de mémoire.

Selon un mode de réalisation, la zone mémoire comporte une seule ligne de bits par colonne connectée aux drains des transistors d'état de la paire de cellules jumelles de la colonne correspondante, et une ligne de contrôle de grille, par rangée de cellules-mémoire, connectée à toutes les grilles de commande des transistors d'états des cellules-mémoires de la rangée correspondante.

Selon un mode de réalisation, les moyens de traitement comprennent un décodeur colonne configuré pour sélectionner individuellement les deux lignes de bit associées aux deux colonnes situées aux deux extrémités de la zone mémoire et, pour sélectionner simultanément deux lignes de bits adjacentes, aussi bien pour l'opération de stockage de l'information que pour l'opération de lecture et de remplacement préalable des bits.

Un tel exemple non limitatif de décodeur colonne permet de mettre en œuvre le stockage et la lecture particuliers mentionnés ci-avant.

Chaque cellule-mémoire a un premier état, par exemple un état effacé, dans lequel elle stocke un bit ayant une première valeur logique, par exemple la valeur logique 1, et un deuxième état, par exemple un état programmé, dans lequel elle stocke un bit ayant une deuxième valeur logique, par exemple la valeur logique 0, et le bit de référence (qui remplace un bit déjà lu pour permette la lecture du bit suivant, a avantageusement la deuxième valeur logique.

Le transistor d'état d'une cellule-mémoire est avantageusement configuré pour être passant lorsque la cellule-mémoire est dans son premier état et pour être bloqué lorsque la cellule-mémoire est dans son deuxième état.

Une façon simple d'obtenir un tel transistor d'état est de prévoir un transistor d'état du type à appauvrissement.

Par ailleurs, selon un mode de réalisation, le transistor d'état a, dans le premier état de la cellule-mémoire, une tension de seuil négative et inférieure à la tension de seuil du transistor d'état de la cellule-mémoire à l'état vierge tandis que dans le deuxième état de la cellule-mémoire, la tension de seuil du transistor d'état est positive et supérieure à la tension de seuil du transistor d'état de la cellule-mémoire à l'état vierge.

Bien que cela ne soit pas indispensable, il est particulièrement intéressant que le canal du transistor d'état de chaque cellule-mémoire comprenne un canal implanté en surface dans le substrat et configuré pour que la cellule-mémoire fonctionne dans un mode d'appauvrissement (« depletion » en langue anglaise).

En effet, cela va permettre par exemple d'appliquer une tension nulle sur la grille de commande en lecture.

En effet, le transistor d'état étant du type à appauvrissement, le caractère passant (« normally on ») du transistor d'état lorsque la cellule-mémoire est dans un état vierge et qu'une tension nulle est appliquée sur la grille de commande, est lié à la valeur de sa tension de seuil dans l'état vierge de la cellule-mémoire qui peut par exemple être choisie négative ou sensiblement nulle.

Et les tensions de seuil du transistor d'état dans les deux états (effacé et programmé) de la cellule-mémoire se situent de part et d'autre de la tension de seuil du transistor d'état de la cellule-mémoire à l'état vierge.

Il devient donc possible de configurer les moyens de traitement pour qu'ils appliquent une tension de lecture nulle sur la grille de commande du transistor d'état d'une cellule-mémoire lors d'une opération de lecture de cette cellule-mémoire.

En effet, avec une telle tension de lecture nulle, il est possible de différencier l'état de la cellule-mémoire puisque le transistor d'état d'une cellule-mémoire dans son premier état (cellule effacée par exemple) sera passant puisque sa tension de seuil sera inférieure à celle d'une cellule vierge et il sera bloqué en présence d'une cellule-mémoire dans son deuxième état (cellule programmée par exemple) puisque la tension de seuil sera cette fois-ci positive.

Lorsque le premier état d'une cellule-mémoire correspond à un état effacé de la cellule et la première valeur logique est un 1, et que le deuxième état d'une cellule-mémoire correspond à un état programmé de la cellule et la deuxième valeur logique est un 0, et les moyens de traitement sont configurés pour, afin de remplacer un bit déjà lu, programmer les deux cellules-mémoires contenant ce bit déjà lu.

Il est particulièrement avantageux que préalablement au stockage de l'information dans la zone mémoire, toutes les cellules-mémoires de la zone mémoire soient dans un état effacé.

En effet dans ce cas il suffit simplement de programmer les cellules-mémoires devant stocker un zéro logique.

Selon un autre aspect, il est proposé un procédé comprenant un stockage d'une information comportant une succession de N bits dans un dispositif de mémoire non volatile.

Le dispositif comprend un plan mémoire comportant au moins une zone mémoire incluant une matrice de cellules mémoires ayant deux rangées et N colonnes, chaque cellule-mémoire comprenant un transistor d'état ayant une grille de commande et une grille flottante, sélectionnable par un transistor de sélection vertical enterré dans un substrat et comportant une grille de sélection enterrée, chaque colonne de cellules-mémoires incluant une paire de cellules-mémoires jumelles, les deux transistors de sélection d'une paire de cellules-mémoires jumelles ayant une grille de sélection commune.

Le stockage des N bits est effectué de sorte qu'à l'exception du dernier bit de la succession, un bit courant de ladite succession est stocké dans deux cellules-mémoires situées sur une même rangée et sur deux colonnes adjacentes et qu'un bit courant et le bit suivant sont respectivement stockés dans deux cellules jumelles.

Selon un mode de mise en œuvre, le procédé comprend, afin de pouvoir lire un bit stocké dans une première cellules jumelle, un remplacement préalable du bit stocké dans la deuxième cellule jumelle par un bit de référence ayant une valeur de référence choisie pour permettre une restitution correcte de la valeur du bit stocké dans la première cellule jumelle.

Selon un mode de mise en œuvre, le procédé comprend en outre une lecture séquentielle des N bits et pour chaque bit de la succession à l'exception du dernier, un remplacement d'un bit courant déjà lu par le bit de référence, avant de pouvoir lire le bit suivant de ladite succession.

Selon un mode de mise en œuvre, le procédé comprend une application d'une tension de lecture nulle sur la grille de commande du transistor d'état d'une cellule-mémoire lors d'une opération de lecture de cette cellule-mémoire.

Selon un mode de mise en œuvre, le procédé comprend une sélection individuelle des deux lignes de bit associées aux deux colonnes situées aux deux extrémités de la zone mémoire et une sélection simultanée de deux lignes de bits adjacentes, aussi bien pour l'opération de stockage de l'information que pour l'opération de lecture et de remplacement préalable des bits.

Selon un mode de mise en œuvre, dans lequel chaque cellule-mémoire possède un premier état correspondant à un état effacé de la cellule dans lequel elle stocke un 1 logique, et un deuxième état correspondant à un état programmé de la cellule dans lequel elle stocke un 0 logique, le procédé comprend, afin de remplacer un bit déjà lu, une programmation des deux cellules-mémoires contenant ce bit déjà lu.

Selon un mode de mise en œuvre, le procédé comprend préalablement au stockage de l'information dans la zone mémoire, un effacement de toutes les cellules-mémoires de la zone mémoire.

Selon un mode de mise en œuvre, le procédé comprend un stockage de ladite information dans plusieurs zones mémoires, et une lecture successive des différentes zones mémoires.

D'autres avantages et caractéristiques de l'invention apparaîtront à l'examen de la description détaillée de modes de mise en œuvre et de réalisation, nullement limitatifs, et des dessins annexés sur lesquels :
[Fig 1]
[Fig 2]
[Fig 3]
[Fig 4]
[Fig 5]
[Fig 6]
[Fig 7]
[Fig 8]
[Fig 9]
[Fig 10]
[Fig 11]
[Fig 12]
[Fig 13]
[Fig 14]
[Fig 15]
[Fig 16]
[Fig 17]
[Fig 18], et
[Fig 19] illustrent schématiquement des modes de mise en œuvre et de réalisation de l'invention.

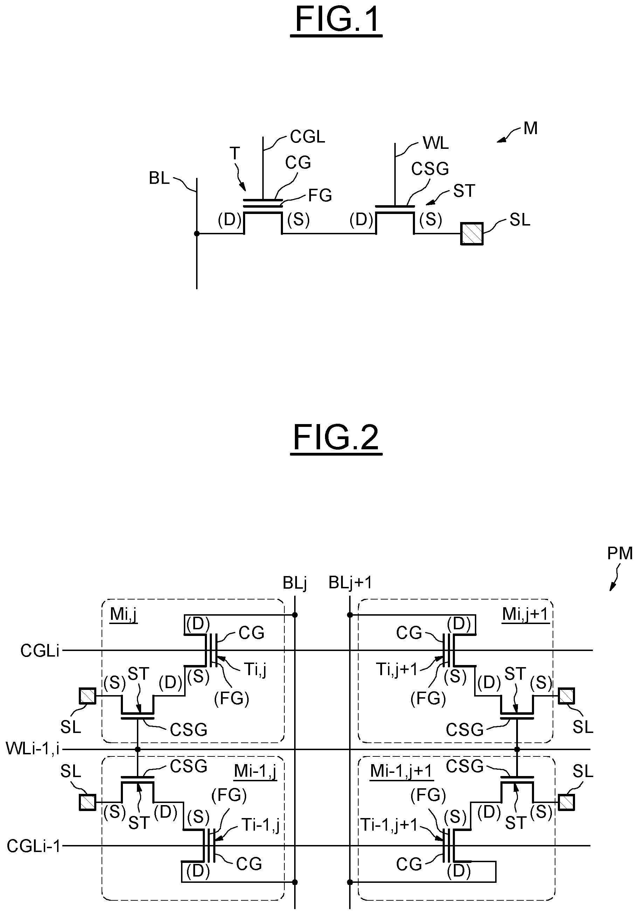

Sur la figure 1, la référence M désigne une cellule mémoire non volatile du type à grille divisée, par exemple du type à transistor de sélection ayant une grille verticale enterrée dans le substrat d'un circuit intégré.

Plus précisément, la cellule mémoire M comporte un transistor d'état T comportant une grille flottante FG surmontée par une grille de commande CG reliée à une ligne de contrôle de grille CGL.

Le drain (D) du transistor d'état T est relié à une ligne de bits BL tandis que la source (S) du transistor d'état T est reliée au drain d'un transistor de sélection ST.

Le transistor de sélection ST comporte une grille CSG reliée à une ligne de mots WL.

La source (S) du transistor de sélection ST est reliée à une ligne de source SL.

A titre d'exemple, la figure 2 représente une structure de plan mémoire PM à une seule ligne de bits par colonne et comprenant des cellules mémoire Mi,j ; Mi,j+1 ; Mi-1,j ; Mi-1,j+1 du type décrit dans la demande de brevet US 2013/0228846.

Les cellules mémoire Mi,j et Mi,j+1 de rang "i" appartiennent à la ligne ou rangée de rang i du plan mémoire et sont reliées à une ligne de mot WLi-1,i et à une ligne de contrôle de grille CGLi.

Les cellules mémoire Mi-1,j et Mi-1,j+1 de rang "i-1" appartiennent à la ligne ou rangée de rang "i-1" du plan mémoire et sont reliées à la ligne de mot WLi-1,i et à une ligne de contrôle de grille CGLi-1.

Les cellules mémoire Mi,j et Mi-1,j de rang "j" appartenant à la colonne j sont accessibles en lecture et écriture par l'intermédiaire d'une seule ligne de bit BLj et les cellules mémoire Mi,j+1 et Mi-1,j+1 de rang "j-1" sont accessibles en lecture et écriture par l'intermédiaire d'une seule ligne de bit BLj+1.

Chaque cellule mémoire comporte un transistor à grille flottante FG, respectivement Ti,j ; Ti,j+1 ; Ti-1,j ; Ti-1,j+1. Les régions de drain (D) des transistors Ti,j et Ti-1,j sont connectées à la ligne de bit BLj et les bornes de drain des transistors Ti,j+1 et Ti-1,j+1 sont connectées à la ligne de bit BLj+1. Les grilles de commande CG des transistors Ti,j et Ti,j+1 sont connectées à la ligne de contrôle de grille CGLi et les grilles de commande CG des transistors à grille flottante Ti-1,j et Ti-1,j+1 sont connectées à la ligne de contrôle de grille CGLi-1.

Chaque transistor à grille flottante a sa borne de source (S) reliée à une ligne de source SL par l'intermédiaire du transistor de sélection ST. Les transistors de sélection ST des cellules mémoire Mi,j et Mi-1,j ont une grille de sélection commune CSG et les deux cellules mémoire sont, de ce fait, dites "jumelles". De même, des cellules mémoire Mi,j+1 et Mi-1,j+1 sont des cellules mémoire jumelles et leurs transistors de sélection ST ont une grille de sélection commune CSG.

Chaque grille de sélection CSG est une grille verticale enterrée dans un substrat dans lequel le plan mémoire PM est réalisé, la ligne de source SL étant également enterrée. Ces grilles de sélection communes CSG de cellules mémoire jumelles, sont connectées à la ligne de mot WLi-1,i.

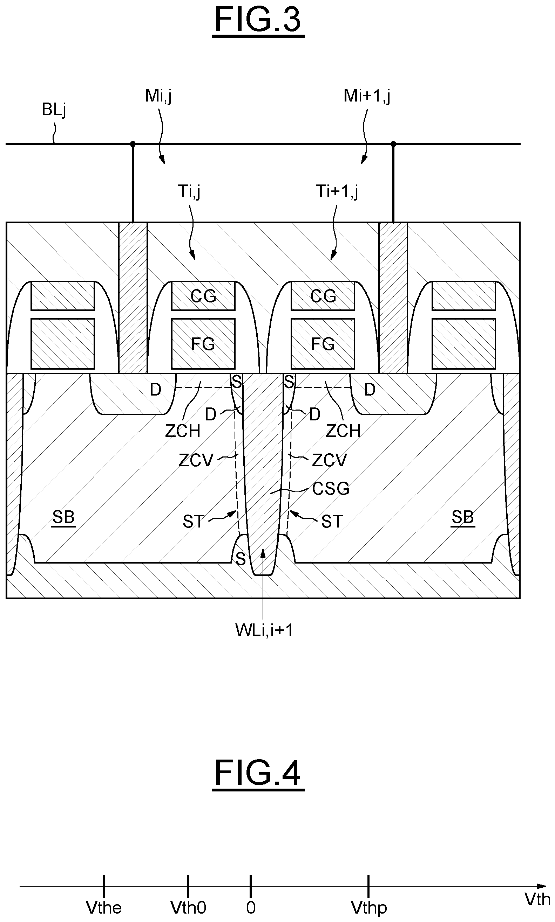

Comme illustré sur la figure 3, et comme indiqué ci-avant, chaque transistor d'état du dispositif de mémoire de la figure 2 coopère avec un transistor de sélection vertical enterré dans le substrat SB.

Le canal ZCH du transistor d'état est référencé ZCH.

Les transistors de sélection ST connectés aux deux transistors d'états Ti,j et Ti+1,j ont chacun un canal vertical ZCV et une grille de sélection commune verticale enterrée CSG. Il convient de noter qu'à des fins de simplifications de la figure, le contact permettant de relier la grille commune enterrée CSG à la ligne de mots correspondante WLi,i+1, n'est pas représenté.

La figure 3 illustre plus précisément deux cellules jumelles Mi,j et Mi+1,j appartenant à la même colonne j et aux deux lignes i et i+1.

Leur drain est connecté à la même ligne de bits BLj qui est la seule ligne de bits pour la colonne j.

Chaque cellule-mémoire a un premier état, par exemple un état effacé, dans lequel elle stocke un bit ayant une première valeur logique, par exemple la valeur logique 1, et un deuxième état, par exemple un état programmé, dans lequel elle stocke un bit ayant une deuxième valeur logique, par exemple la valeur logique 0.

Le transistor d'état d'une cellule-mémoire est avantageusement configuré pour être passant lorsque la cellule-mémoire est dans son premier état et pour être bloqué lorsque la cellule-mémoire est dans son deuxième état.

Une façon simple d'obtenir un tel transistor d'état est de prévoir par exemple un transistor d'état du type à appauvrissement comme décrit dans la demande brevet français publiée sous le n° 3049380.

Comme il est bien connu par l'homme du métier, le transistor MOS à appauvrissement est passant sans tension de commande appliquée sur la grille de commande du transistor d'état (grille de commande reliée à la masse), et par conséquent sur la grille flottante par couplage capacitif. Le transistor d'état est donc dit « normally on ». Par contre, le transistor devient de moins en moins conducteur au fur et à mesure de la tension de commande présente sur la grille de commande augmente en valeur absolue (devient de plus en plus négative) pour finalement se bloquer au-delà d'une tension de blocage.

Le canal ZCH du transistor d'état est avantageusement un canal surfacique de sorte qu'il puisse être possible de pouvoir bloquer la conduction du canal par application d'une tension de commande acceptable sur la grille de commande du transistor d'état.

L'énergie d'implantation des dopants définit la profondeur du canal ZCH. A titre indicatif, cette énergie peut être comprise entre 5keV et 100keV conduisant alors à une profondeur de canal de l'ordre de 100 nm.

Dans le cas d'un canal de type de conductivité N, les dopants implantés peuvent être par exemple de l'arsenic As, et la concentration de dopants détermine la tension de seuil Vth0 du transistor d'état d'une cellule mémoire à l'état vierge. Le transistor d'état est ici configuré pour avoir une telle tension de seuil Vth0 négative. A cet égard, on peut utiliser une dose de dopants implantés comprise entre 10¹² atomes/cm² et 10¹⁴ atomes/cm³.

Avec une telle dose de dopants on peut obtenir une tension Vth0 négative comprise par exemple entre -1 volt et -0,5 volt.

Sur la figure 4, on a représenté schématiquement les différentes tensions de seuil Vthe, Vth0 et Vthp correspondant respectivement par exemple à des cellules-mémoires effacées, vierges et programmées.

En mode de lecture, on peut appliquer une tension de lecture nulle sur la grille de commande CG du transistor d'état et appliquer une tension positive sur la ligne de bits BL.

Le transistor d'état étant à appauvrissement avec une tension Vth0 négative, il est normalement passant pour une cellule mémoire vierge, c'est-à-dire lorsqu'aucune charge n'est présente dans la grille flottante.

Il ressort alors de la figure 4 qu'un transistor d'état d'une cellule mémoire effacée sera passant tandis que le transistor d'état d'une cellule mémoire programmée sera bloqué. Et, le fait d'appliquer une tension nulle sur la grille de commande et par conséquent sur la grille flottante FG du transistor d'état, n'induit pas de stress en lecture (« read stress »).

Par ailleurs la programmation ou l'effacement d'un transistor à grille flottante s'effectue ici par l'injection ou l'extraction des charges électriques dans la grille du transistor par injection d'électrons chauds au moyen de haute(s) tension(s).

Plus particulièrement, l'effacement d'une cellule mémoire est assuré en combinant une tension positive appliquée au substrat à une tension négative appliquée à la grille de commande de son transistor d'état à grille flottante.

En ce qui concerne la cellule jumelle, si l'on souhaite qu'elle ne soit pas simultanément effacée, on applique une tension positive sur la grille de commande de son transistor d'état.

La programmation d'une cellule mémoire peut être assurée par exemple en appliquant une tension positive à la ligne de bit concernée, en appliquant une tension nulle au substrat, et une tension positive sur la grille de commande de son transistor d'état à grille flottante.

La sélection d'une telle cellule mémoire à programmer s'effectue en appliquant une tension positive supérieure à la tension de seuil du transistor d'état, sur la ligne de mot concernée.

En ce qui concerne la cellule jumelle, si l'on souhaite qu'elle ne soit pas simultanément programmée, on applique une tension faiblement négative, par exemple -0,5 Volt ou -1 Volt, ou nulle sur la grille de commande de son transistor d'état.

Enfin, comme indiqué ci-avant, la lecture d'une cellule mémoire est assurée en appliquant une tension nulle à la grille de commande CG de son transistor d'état, ainsi qu'une tension positive à la ligne de bit correspondante.

La sélection d'une telle cellule mémoire à lire s'effectue en appliquant une tension positive supérieure à la tension de seuil du transistor d'état, sur la ligne de mot concernée.

En pratique on appliquera en mode lecture une tension nulle sur toutes les cellules du plan mémoire.

De ce fait deux cellules jumelles sélectionnées seront simultanément lues.

Et si en plus le décodeur colonne est configuré, comme on le verra plus en détails ci-après, pour sélectionner simultanément deux lignes de bits adjacentes, les deux paires correspondantes de cellules jumelles seront simultanément lues.

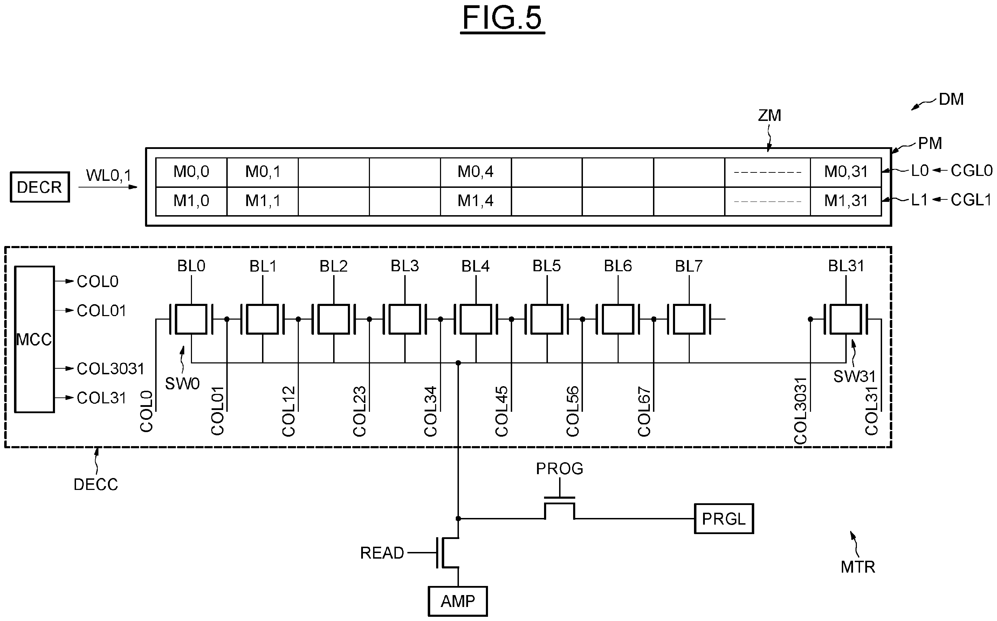

On se réfère maintenant plus particulièrement aux figures 5 et suivantes pour décrire plus précisément des modes de réalisation et de mise en œuvre de l'invention.

Sur la figure 5, la référence DM désigne un dispositif de mémoire comportant un plan mémoire PM incluant une zone mémoire ZM.

Cette zone mémoire ZM contient ici une matrice de cellules-mémoire Mi,j ayant deux rangées ou lignes L0 et L1 et N colonnes, ici 32 colonnes.

Les cellules-mémoire Mi,j sont des cellules-mémoire telles que celles décrites en référence aux figures précédentes.

Dans cet exemple, i désigne l'indice de rangée ou ligne et i vaut 0 ou 1.

L'indice j désigne l'indice de colonne et varie de 0 à 31 dans cet exemple.

La zone mémoire ZM est destinée à stocker une information comportant N données binaires D0-D31.

Le dispositif de mémoire DM comporte également des moyens de traitement MTR comportant notamment un décodeur lignes DECR, de structure classique, et configuré pour délivrer des tensions sur la ligne de mots WL0,1 ainsi que sur les lignes de contrôle de grille CGL0 et CGL1.

Les moyens de traitement comportent également un décodeur colonnes DECC.

Ce décodeur colonnes DECC comporte ici un ensemble de commutateurs SW0-SW31 comportant chacun deux transistors MOS en parallèle.

Une première borne du commutateur SWj est connectée à la ligne de bits correspondante BLj.

Une deuxième borne du commutateur SWJ est connectée soit à un circuit amplificateur de lecture AMP par l'intermédiaire d'un transistor MOS commandé sur sa grille par un signal de lecture READ ou bien à un moyen de programmation PRGL, de structure classique, par l'intermédiaire d'un autre transistor MOS commandé sur sa grille par un signal de commande de programmation PROG.

Ces signaux READ et PROG sont délivrés par les moyens de traitement MTR selon que l'on se situe dans une phase de lecture ou dans une phase de programmation.

Comme illustré sur la figure 5, le décodeur colonnes DECC est configuré pour sélectionner individuellement les deux lignes de bits BL0 et BL31 associées aux deux colonnes situées aux deux extrémités de la zone mémoire ZM, par l'intermédiaire des signaux logiques COL0 et COL31.

Par ailleurs, le décodeur colonnes est également configuré pour sélectionner simultanément deux lignes de bits adjacentes BLj et BLj+1 par le signal logique COLjj+1.

Cette sélection individuelle des deux lignes de bits BL0 et BL31 et la sélection simultanée de deux lignes de bits adjacentes est effectuée aussi bien pour l'opération de stockage de l'information D0-D31 dans les cellules-mémoire de la zone mémoire ZM que pour l'opération de lecture qui, comme on le verra plus en détail ci-après, comporte des remplacements préalables de bits par un bit de référence, en l'espèce un bit de valeur logique 0.

Les signaux logiques COLO, COL31 et COL jj+1 sont délivrés par des moyens logique MCC.

Comme indiqué ci-avant, la zone mémoire est destinée à stocker 32 bits de données D0-D31.

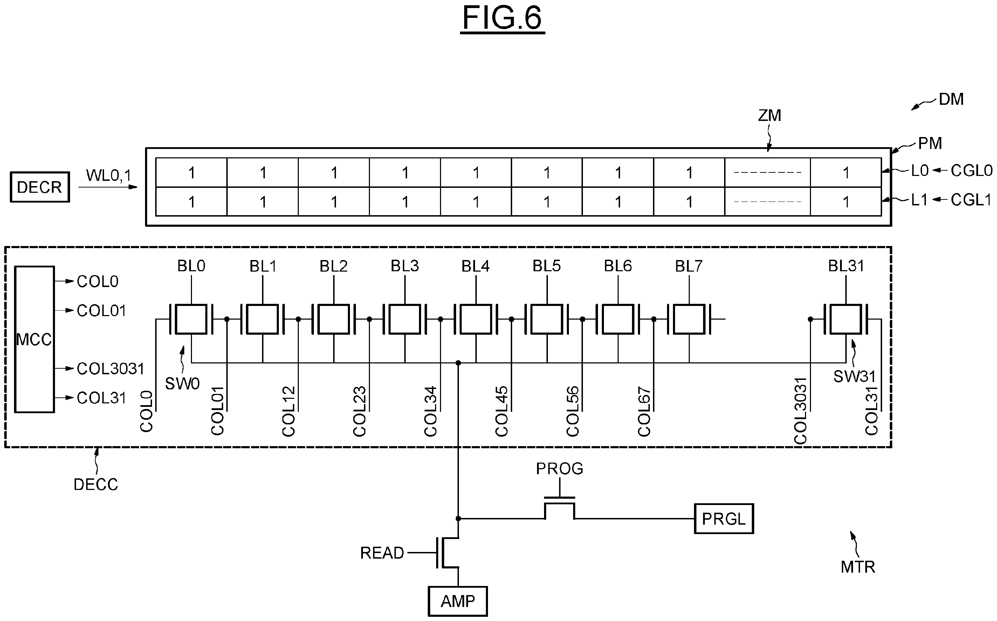

Et, comme illustré sur la figure 6, préalablement au stockage de cette information dans la zone mémoire ZM, toutes les cellules-mémoire de la zone mémoire ZM sont dans un état effacé, c'est-à-dire qu'elles contiennent toutes la valeur logique 1.

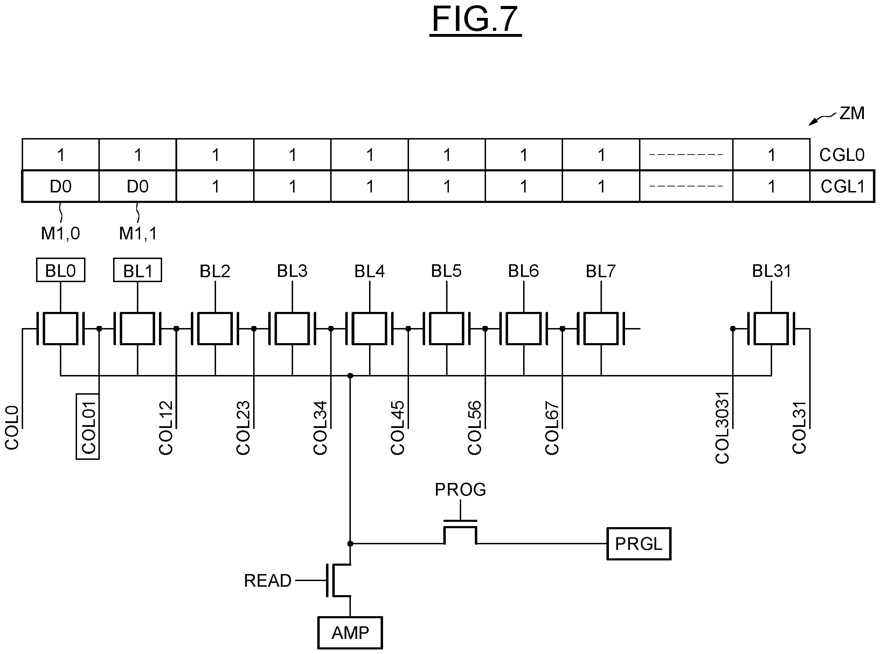

On se réfère maintenant plus particulièrement aux figures 7 à 10 pour illustrer l'écriture successive des N bits D0-D31 de l'information dans la zone mémoire ZM.

D'une façon générale, puisque l'état initial des cellules-mémoire de la zone mémoire ZM est un état effacé, c'est-à-dire contenant un « 1 » logique, on n'effectuera aucune opération dans une cellule mémoire pour y écrire une donnée ayant comme valeur logique « 1 ».

Par contre, on effectuera une opération de programmation d'une cellule mémoire dans le cas où la donnée à écrire dans cette cellule est un « 0 ».

Les tensions à appliquer sur la ligne de bits, le substrat, la grille de commande et la ligne de mots pour sélectionner et programmer une cellule ont été indiquées ci-avant.

De même les tensions à appliquer sur la ligne de bits, la grille de commande et la ligne de mots pour sélectionner et lire une cellule ont été indiquées ci-avant.

Sur la figure 7, le décodeur colonnes DECC sélectionne, à l'aide du signal logique COL1, les deux lignes de bits BL0 et BL1.

Par ailleurs, la ligne de contrôle de grille CGL1 est sélectionnée.

De ce fait, la donnée D0 est écrite à la fois dans la cellule-mémoire M1,0 et dans la cellule-mémoire M1,1.

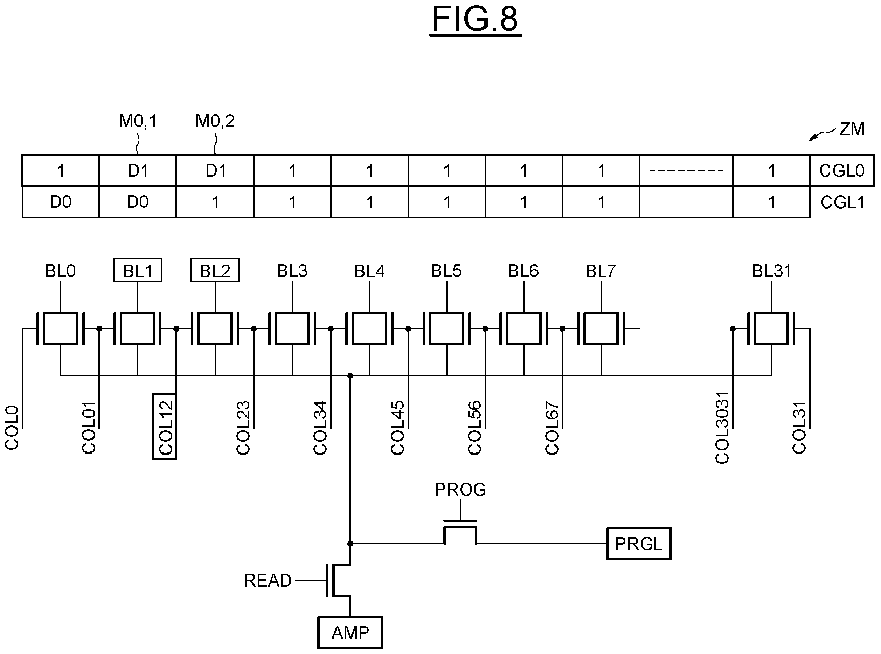

Puis, comme illustré sur la figure 8, le décodeur colonne sélectionne les deux lignes de bits BL1 et BL2 à l'aide du signal logique COL12.

Par ailleurs, c'est cette fois-ci la ligne de contrôle de grille CGL0 qui est sélectionnée.

En conséquence, la deuxième donnée D1 de l'information est stockée simultanément dans les deux cellules-mémoire M0,2 et M0,3 de la première ligne L0.

L'opération d'écriture se poursuit ensuite séquentiellement jusqu'à l'écriture de la dernière donnée D31 de l'information dans la cellule-mémoire M0,31.

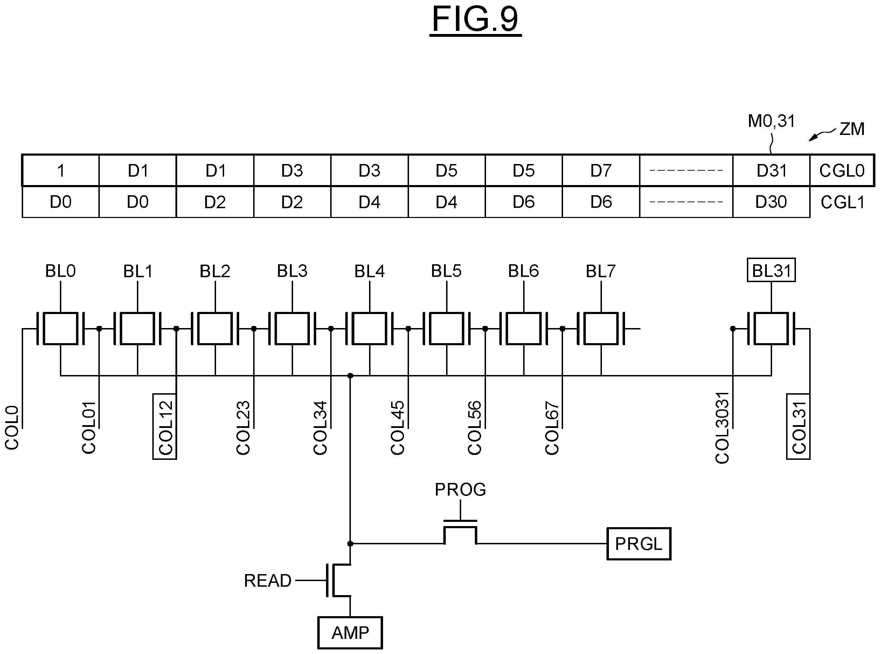

Ceci est effectué en sélectionnant la ligne de bits BL31 au moyen du signal logique COL31 et en sélectionnant la ligne de contrôle de grille CGL0 (figure 9).

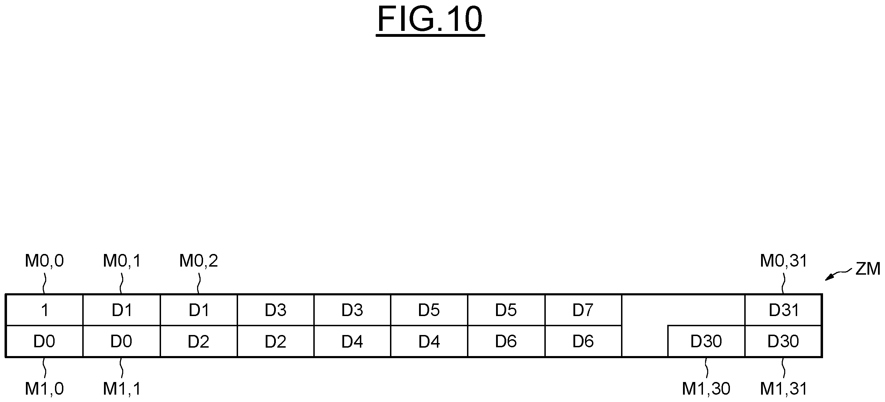

A la fin de cette opération d'écriture, on obtient, comme illustré sur la figure 10, un remplissage de la zone mémoire en damier de telle sorte qu'une donnée, à l'exception de la dernière donnée D31, est stockée dans deux cellules-mémoire adjacentes d'une même ligne et que deux données successives sont respectivement stockées dans deux cellules jumelles d'une même colonne.

Par ailleurs, la cellule jumelle M0,0 de celle M1,0 stockant la donnée D0 stocke la valeur 1 tandis que la dernière donnée D31 est stockée dans la cellule-mémoire M0,31 jumelle de la cellule-mémoire M1,31 stockant la donnée D30.

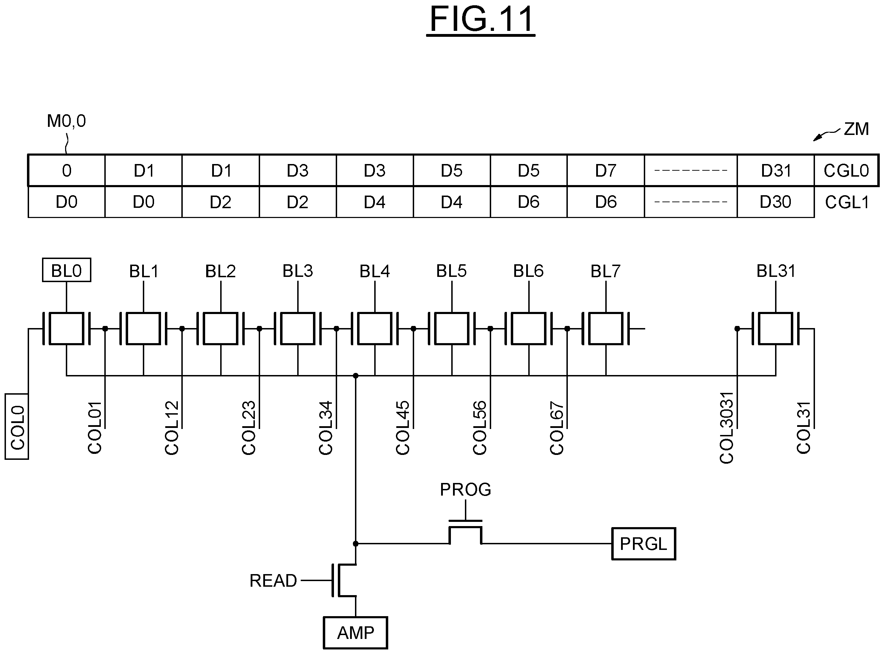

On se réfère maintenant plus particulièrement aux figures 11 à 18 pour illustrer un exemple de lecture de l'information stockée dans la zone mémoire ZM.

Puisque la tension nulle (masse GND) est appliquée en lecture sur les grilles de commande de toutes les cellules-mémoire de la zone mémoire, la lecture d'une première cellule-mémoire jumelle d'une colonne entraîne simultanément la lecture de la deuxième cellule jumelle.

Or, si la première cellule jumelle contient un « 1 » logique, alors ce « 1 » logique va masquer la valeur lue de la donnée située dans la deuxième cellule jumelle.

En effet, la lecture de ces deux cellules jumelles va toujours donner un « 1 » logique quelle que soit la valeur de la donnée stockée.

C'est la raison pour laquelle il est nécessaire, avant de lire une cellule-mémoire, de remplacer la valeur stockée dans sa cellule jumelle par un bit de référence choisi de façon à permettre la restitution correcte de la donnée stockée. En l'espèce, ce bit de référence aura la valeur « 0 » ce qui correspond à une programmation préalable de la cellule jumelle de façon à y stocker un « 0 ».

Ceci est illustré sur la figure 11.

Plus précisément, à l'aide du signal logique COLO, on sélectionne la ligne de bits BL0 et, à l'aide du signal de contrôle de ligne CGL0, on programme la cellule mémoire M0,0 de façon à y stocker un « 0 » logique.

Puis, on peut procéder à la lecture des deux cellules jumelles M0,0 de façon à y stocker un « 0 » logique.

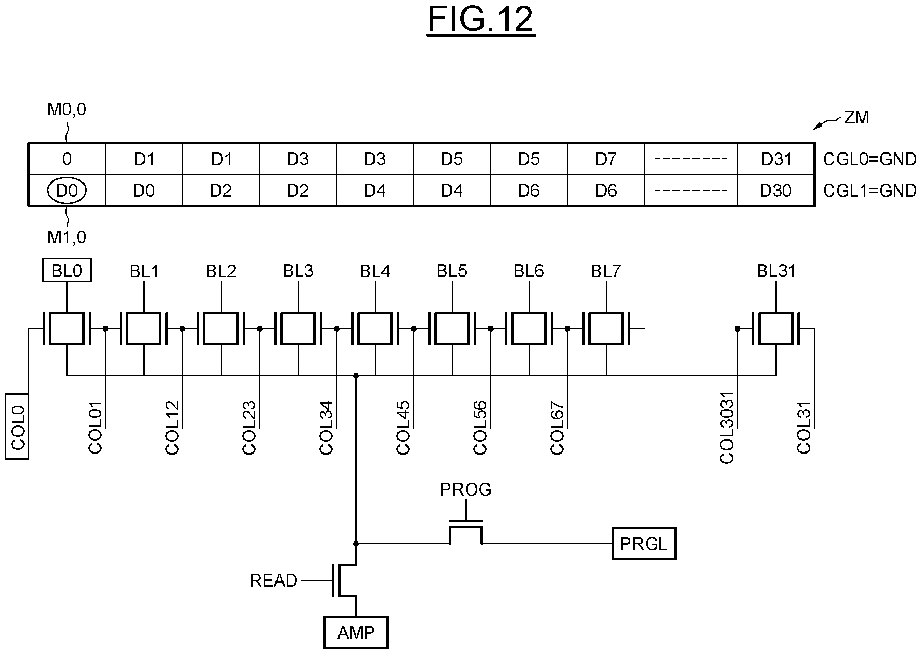

Puis, on peut procéder à la lecture des deux cellules jumelles M0,0 et M1,0 toujours en sélectionnant la ligne de bits BL0 à l'aide du signal logique COLO, comme illustré sur la figure 12.

Et, cette fois-ci, la donnée D0 est correctement lue.

En effet, si la donnée D0 est égale 0, alors la valeur 0 sera effectivement lue par le circuit amplificateur de lecture AMP.

Et, si la valeur logique de la donnée D0 est égale à 1, alors un « 1 » logique sera lu par le circuit amplificateur de lecture AMP.

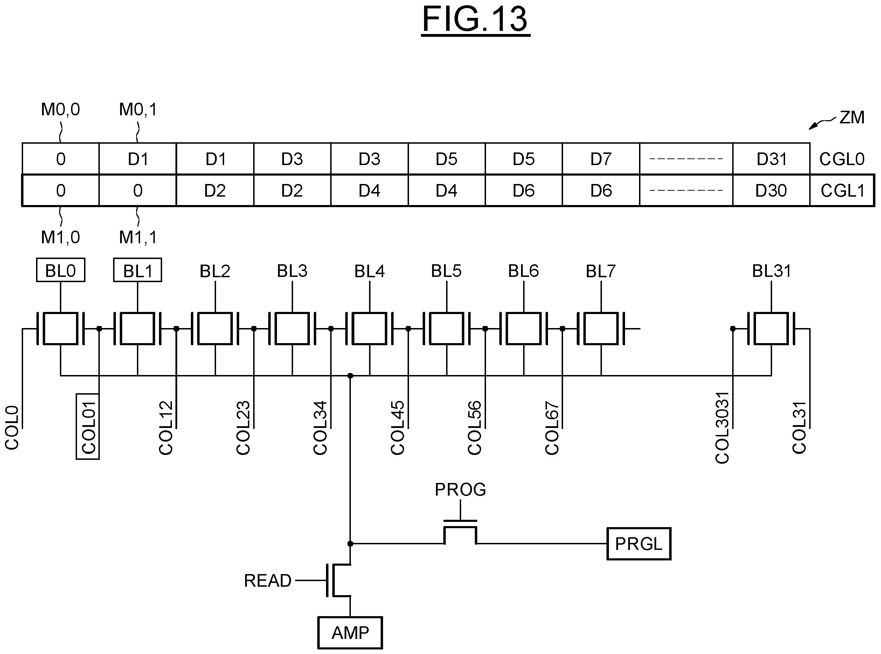

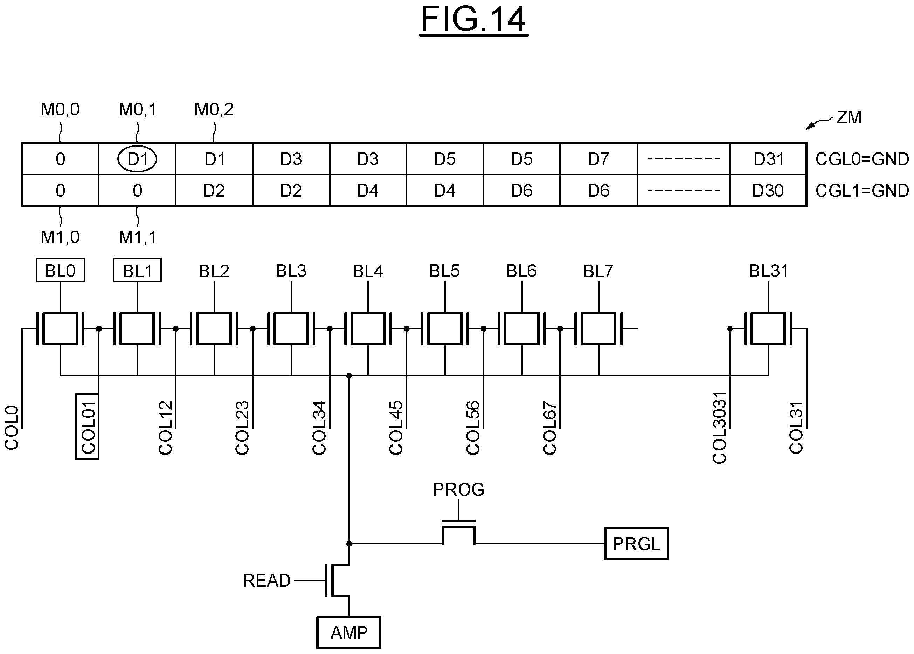

On procède ensuite comme illustré sur les figures 13 et 14 à la lecture de la donnée D1.

Et, comme cette fois-ci le décodeur colonnes va sélectionner les deux lignes de bits BL0 et BL1 simultanément, et que la tension nulle GND est appliquée sur les grilles de commande de transistors d'état de toutes les cellules-mémoire, il va y avoir une lecture simultanée des deux cellules jumelles situées sur la colonne « 0 » et des deux cellules jumelles situées sur la colonne « 1 ».

Aussi, de façon à obtenir une restitution correcte de la valeur logique de la donnée D1, il est nécessaire, préalablement à la lecture de cette donnée D1, non seulement de programmer la cellule jumelle de la cellule D1 avec la valeur « 0 » mais également de programmer la cellule qui comportait la donnée D0 précédemment lue.

Ceci est illustré sur la figure 13.

On voit que dans cette étape préalable de programmation, de par la sélection des lignes de bits BL0 et BL1 par le signal logique COL01 et de par l'application de la tension de programmation sur la ligne de contrôle de grille CGL1, on programme avec la valeur logique « 0 » les cellules-mémoire M1,0 et M1,1.

De ce fait, comme illustré sur la figure 14, la sélection des deux lignes de bits BL0 et BL1 et l'application de la tension nulle GND sur les grilles de commande des transistors d'état conduisent à lire simultanément la valeur logique de la donnée D1 et les trois valeurs logique « 0 » stockées dans les cellules-mémoires M0,0, M1,0 et M1,1.

De ce fait, la valeur logique de la donnée D1 est correctement restituée. En effet, si cette donnée est égale à 0, alors le circuit amplificateur de lecture lira effectivement un « 0 » tandis que si cette valeur logique est égale à 1, le circuit amplificateur de lecture lira effectivement un « 1 ».

Il convient donc de noter ici que non seulement la programmation préalable permet d'effectuer une restitution correcte de la donnée à lire mais que cette programmation préalable détruit également la donnée qui a été précédemment lue.

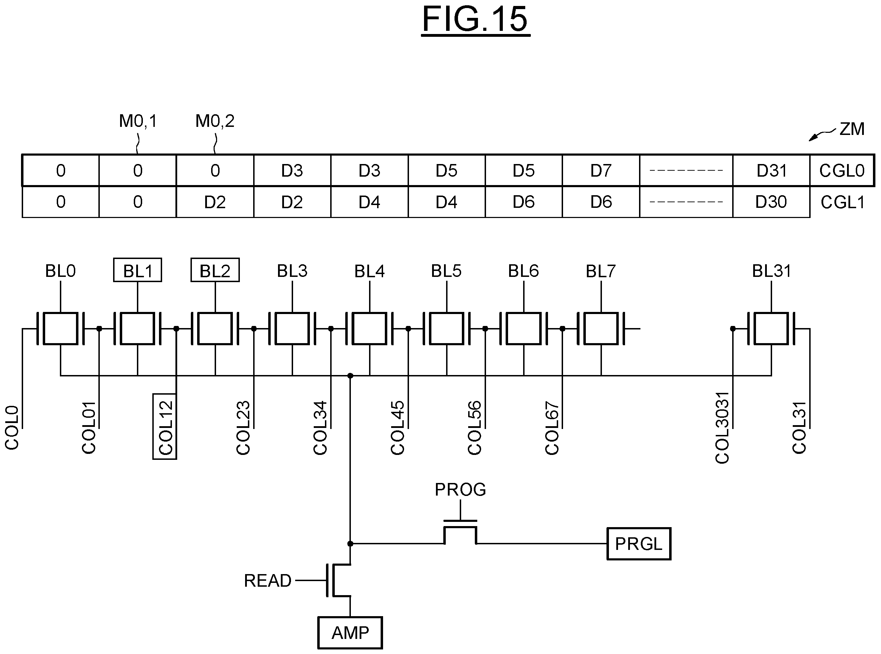

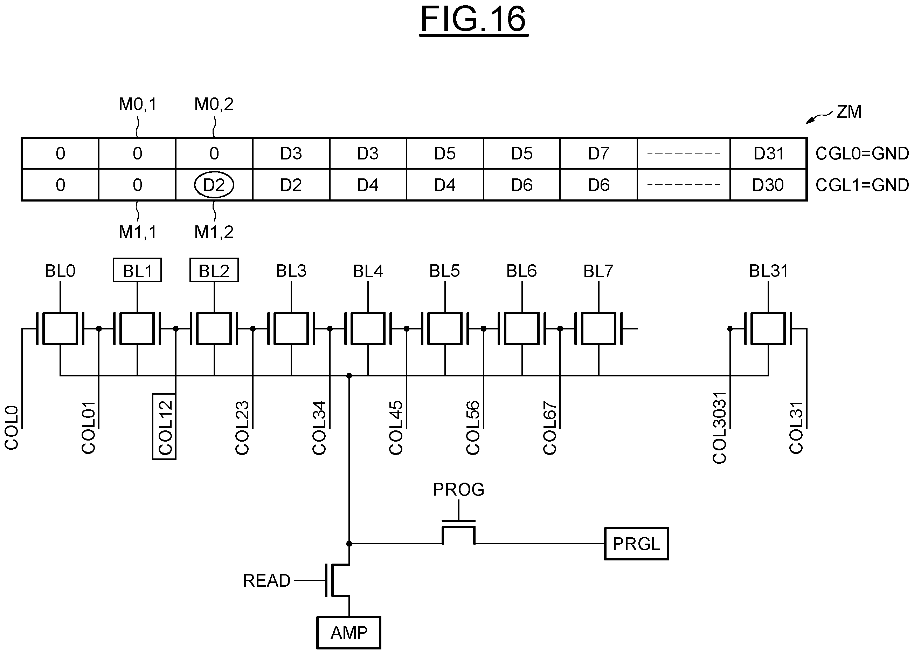

Les figures 15 et 16 illustrent la lecture de la donnée suivante D2.

Préalablement à cette lecture, on effectue une programmation des cellules M0,1 et M0,2 (figure 15) puis une lecture de la donnée D2 stockée dans la cellule-mémoire M1,2 (figure 16).

La donnée D1 a de ce fait été détruite.

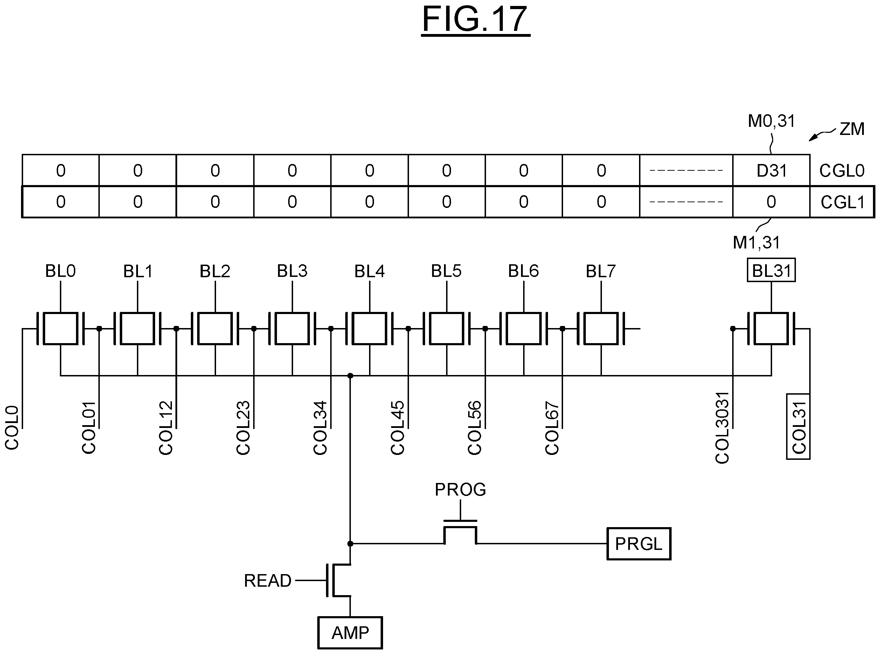

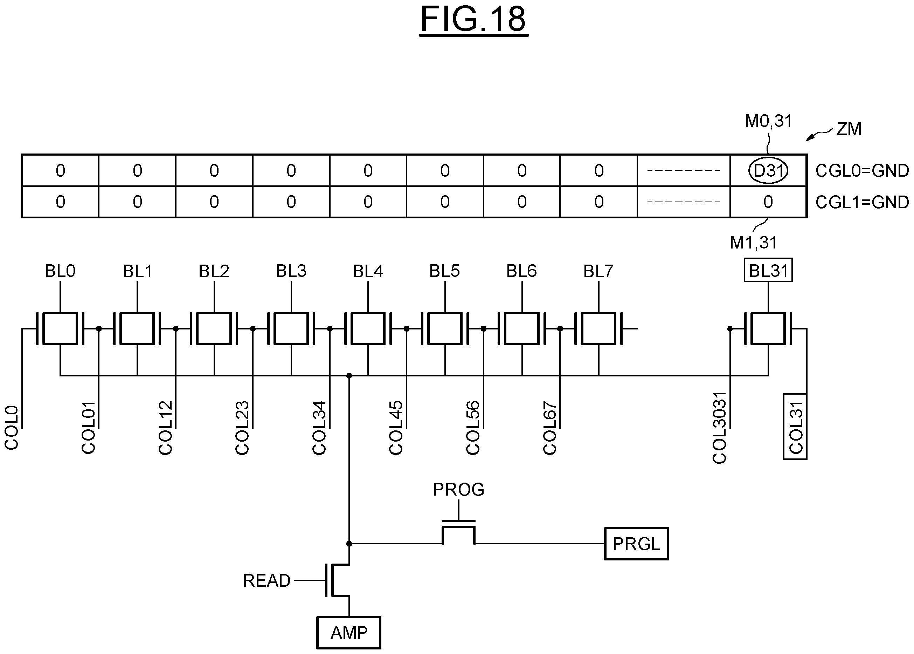

Les figures 17 et 18 illustrent la lecture de la dernière donnée D31.

A cet égard, comme illustré sur la figure 17, on procède à une programmation préalable de la cellule jumelle M1,31 puis comme illustré sur la figure 18 à une lecture de la cellule D31 stockée dans la cellule-mémoire M0,31.

A l'issue de cette lecture, on remarque que toutes les cellules-mémoire à l'exception de la dernière cellule M0,31, stockent un 0 logique.

La lecture des N données binaires de l'information stockée a donc détruit tous les bits de cette information à l'exception du dernier.

Et, on ne peut donc plus lire une nouvelle fois cette information.

Le dispositif de mémoire se comporte donc ici comme une mémoire lisible une seule fois.

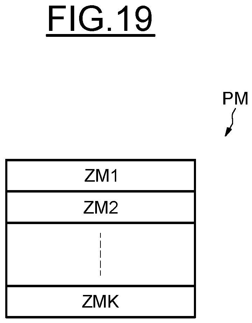

Si l'on souhaite offrir un dispositif de mémoire qui puisse être lu un nombre prédéterminé de fois, par exemple K fois, alors on peut, comme illustré schématiquement sur la figure 19, prévoir un plan-mémoire PM comportant K zones ZM, ZM1-ZMK.

Ces zones vont être successivement lues comme indiqué ci-avant pour la zone ZM, de façon à permettre une lecture de l'information uniquement K fois.

## Revendications

1. Dispositif de mémoire non volatile, comprenant un plan mémoire (PM) comportant au moins une zone mémoire(ZM) incluant une matrice de cellules mémoires (Mi,j) ayant deux rangées et N colonnes, chaque cellule-mémoire comprenant un transistor d'état ayant une grille de commande et une grille flottante, sélectionnable par un transistor de sélection vertical enterré dans un substrat et comportant une grille de sélection enterrée, chaque colonne de cellules-mémoires incluant une paire de cellules-mémoires jumelles, les deux transistors de sélection d'une paire de cellules-mémoires jumelles ayant une grille de sélection commune, et des moyens de traitement (MTR) configurés pour stocker dans la zone mémoire une information (D0-D31) comportant une succession de N bits de sorte que, à l'exception du dernier bit de la succession, un bit courant de ladite succession est stocké dans deux cellules-mémoires situées sur une même rangée et sur deux colonnes adjacentes et un bit courant et le bit suivant sont respectivement stockés dans deux cellules jumelles.

2. Dispositif selon la revendication 1, dans lequel les moyens de traitement (MTR) sont configurés pour, afin de pouvoir lire un bit stocké dans une première cellule jumelle, remplacer au préalable le bit stocké dans la deuxième cellule jumelle par un bit de référence ayant une valeur de référence choisie pour permettre une restitution correcte de la valeur du bit stocké dans la première cellule jumelle.

3. Dispositif selon la revendication 2, dans lequel les moyens de traitement (MTR) sont en outre configurés pour lire séquentiellement les N bits de l'information et remplacer un bit courant déjà lu de ladite information par le bit de référence avant de pouvoir lire le bit suivant de ladite succession.

4. Dispositif selon l'une des revendications 1 à 3, dans lequel la zone mémoire (ZM) comporte une seule ligne de bits par colonne, connectée aux drains des transistors d'état de la paire de cellules jumelles de la colonne correspondante, et une ligne de contrôle de grille, par rangée de cellules-mémoire, connectée à toutes les grilles de commande des transistors d'états des cellules-mémoires de la rangée correspondante.

5. Dispositif selon l'une des revendications 1 à 4, dans lequel les moyens de traitement (MTR) comprennent un décodeur colonne (DECC) configuré pour sélectionner individuellement les deux lignes de bit associées aux deux colonnes situées aux deux extrémités de la zone mémoire et pour sélectionner simultanément deux lignes de bits adjacentes (BLj ; BLj+1), aussi bien pour l'opération de stockage de l'information que pour l'opération de lecture et de remplacement préalable des bits.

6. Dispositif selon l'une des revendications précédentes prise en combinaison avec la revendication 2 ou 3, dans lequel chaque cellule-mémoire (Mi,j) a un premier état dans lequel elle stocke un bit ayant une première valeur logique et un deuxième état dans lequel elle stocke un bit ayant une deuxième valeur logique 1, et le bit de référence a la deuxième valeur logique.

7. Dispositif selon la revendication 6, dans lequel le transistor d'état d'une cellule-mémoire (Mi,j) est configuré pour être passant lorsque la cellule-mémoire est dans son premier état et pour être bloqué lorsque la cellule-mémoire est dans son deuxième état.

8. Dispositif selon la revendication 7, dans lequel le transistor d'état est du type à appauvrissement, et le transistor d'état a, dans le premier état de la cellule-mémoire (Mi,j), une tension de seuil négative et inférieure à la tension de seuil du transistor d'état de la cellule-mémoire à l'état vierge tandis que dans le deuxième état de la cellule-mémoire, la tension de seuil du transistor d'état est positive et supérieure à la tension de seuil du transistor d'état de la cellule-mémoire à l'état vierge.

9. Dispositif selon la revendication 8, dans lequel les moyens de traitement (MTR) sont configurés pour appliquer une tension de lecture nulle sur la grille de commande du transistor d'état d'une cellule-mémoire lors d'une opération de lecture de cette cellule-mémoire.

10. Dispositif selon la revendication 8 ou 9, dans lequel le premier état d'une cellule-mémoire (Mi,j) correspond à un état effacé de la cellule et la première valeur logique est un 1, le deuxième état d'une cellule-mémoire correspond à un état programmé de la cellule et la deuxième valeur logique est un 0, et les moyens de traitement sont configurés pour, afin de remplacer un bit déjà lu, programmer les deux cellules-mémoires contenant ce bit déjà lu.

11. Dispositif selon la revendication 10, dans lequel préalablement au stockage de l'information dans la zone mémoire (ZM), toutes les cellules-mémoires (Mi,j) de la zone mémoire sont dans un état effacé.

12. Dispositif selon l'une des revendications précédentes, comprenant plusieurs zones mémoires (ZM1-ZMK) destinées à contenir la même information de N bits, et les moyens de traitement sont configurés pour lire successivement les différentes zones mémoires.

13. Procédé, comprenant un stockage d'une information comportant une succession de N bits (D0-D31) dans un dispositif de mémoire non volatile (DM), le dispositif comprenant un plan mémoire (PM) comportant au moins une zone mémoire (ZM) incluant une matrice de cellules mémoires (Mi,j) ayant deux rangées et N colonnes, chaque cellule-mémoire comprenant un transistor d'état ayant une grille de commande et une grille flottante, sélectionnable par un transistor de sélection vertical enterré dans un substrat et comportant une grille de sélection enterrée, chaque colonne de cellules-mémoires incluant une paire de cellules-mémoires jumelles (Mi,j ; Mi-1,j), les deux transistors de sélection d'une paire de cellules-mémoires jumelles ayant une grille de sélection commune, le stockage des N bits étant effectué de sorte qu'à l'exception du dernier bit de la succession, un bit courant de ladite succession est stocké dans deux cellules-mémoires situées sur une même rangée et sur deux colonnes adjacentes et qu'un bit courant et le bit suivant sont respectivement stockés dans deux cellules jumelles.

14. Procédé selon la revendication 13, comprenant, afin de pouvoir lire un bit stocké dans une première cellules jumelle (Mi,j), un remplacement préalable du bit stocké dans la deuxième cellule jumelle (Mi-1,j) par un bit de référence ayant une valeur de référence choisie pour permettre une restitution correcte de la valeur du bit stocké dans la première cellule jumelle.

15. Procédé selon la revendication 14, comprenant en outre une lecture séquentielle des N bits (D0-D31) et un remplacement d'un bit courant déjà lu de ladite succession par le bit de référence avant de pouvoir lire le bit suivant de ladite succession.

16. Procédé selon la revendication 14 ou 15, comprenant une application d'une tension de lecture nulle sur la grille de commande du transistor d'état d'une cellule-mémoire (Mi,j) lors d'une opération de lecture de cette cellule-mémoire.

17. Procédé selon l'une des revendications 13 à 16, comprenant une sélection individuelle des deux lignes de bit associées aux deux colonnes situées aux deux extrémités de la zone mémoire et une sélection simultanée de deux lignes de bits adjacentes (BLj ; BLj+1), aussi bien pour l'opération de stockage de l'information que pour l'opération de lecture et de remplacement préalable des bits.

18. Procédé selon l'une des revendications 13 à 17, dans lequel chaque cellule-mémoire (Mi,j) possède un premier état correspondant à un état effacé de la cellule dans lequel elle stocke un 1 logique, et un deuxième état correspondant à un état programmé de la cellule dans lequel elle stocke un 0 logique, et le procédé comprend, afin de remplacer un bit déjà lu, une programmation des deux cellules-mémoires contenant ce bit déjà lu.

19. Procédé selon la revendication 18, comprenant préalablement au stockage de l'information dans la zone mémoire (ZM), un effacement de toutes les cellules-mémoires de la zone mémoire.

20. Procédé selon l'une des revendications 13 à 19, comprenant un stockage de ladite information dans plusieurs zones mémoires (ZM1-ZMK), et une lecture successive des différentes zones mémoires.

## Patentansprüche

1. Nichtflüchtige Speichervorrichtung, eine Speicherebene (PM) umfassend, die mindestens einen Speicherbereich (ZM) enthält, der eine Speicherzellenmatrix (Mi,j) einschließt, die zwei Reihen und N Spalten aufweist, wobei jede Speicherzelle einen Zustandstransistor umfasst, der ein Steuer-Gate und ein Floating-Gate aufweist, die durch einen Transistor vertikaler Auswahl auswählbar sind, der in einem Substrat eingebettet ist und ein eingebettetes Auswahl-Gate enthält, wobei jede Speicherzellen-Spalte ein Paar Zwillings-Speicherzellen einschließt, wobei die zwei Auswahltransistoren eines Paares von Zwillings-Speicherzellen ein gemeinsames Auswahl-Gate aufweisen und Verarbeitungsmittel (MTR), die konfiguriert sind, um im Speicherbereich eine Information (D0-D31) zu speichern, die eine Folge von N Bits enthält, so dass, mit Ausnahme des letzten Bit der Folge, ein aktuelles Bit der Folge in zwei Speicherzellen gespeichert wird, die sich in derselben Reihe und in zwei benachbarten Spalten befinden, und jeweils ein aktuelles Bit und das nächste Bit in zwei Zwillingszellen gespeichert werden.

2. Vorrichtung nach Anspruch 1, wobei die Verarbeitungsmittel (MTR) konfiguriert sind, um, damit ein Bit gelesen werden kann, das in einer ersten Zwillingszelle gespeichert ist, das in der zweiten Zwillingszelle gespeicherte Bit vorangehend durch ein Referenz-Bit zu ersetzen, das einen Referenzwert aufweist, der ausgewählt ist, um eine korrekte Wiedergabe des Wertes des Bit zu ermöglichen, das in der ersten Zwillingszelle gespeichert ist.

3. Vorrichtung nach Anspruch 2, wobei die Verarbeitungsmittel (MTR) ferner konfiguriert sind, um die N Bits der Information sequentiell zu lesen und ein aktuelles Bit der Information, das bereits gelesen wurde, durch das Referenz-Bit zu ersetzen, bevor das nächste Bit der Folge gelesen werden kann.

4. Vorrichtung nach einem der Ansprüche 1 bis 3, wobei der Speicherbereich (ZM) eine einzelne Linie von Bits pro Spalte enthält, die mit den Drains der Zustandstransistoren des Zwillingszellenpaares der entsprechenden Spalte verbunden ist, und eine Gate-Steuerlinie, pro Speicherzellenreihe, die mit allen Steuer-Gates der Zustandstransistoren der Speicherzellen der entsprechenden Reihe verbunden ist.

5. Vorrichtung nach einem der Ansprüche 1 bis 4, wobei die Verarbeitungsmittel (MTR) einen Spaltendecoder (DECC) umfassen, der konfiguriert ist, um die zwei Bit-Linien individuell auszuwählen, die den zwei Spalten zugeordnet sind, die sich an den zwei Enden des Speicherbereichs befinden, und gleichzeitig zwei benachbarte Bit-Linien (BLj; BLj+1) auszuwählen, sowohl für den Vorgang der Speicherung der Information als auch für den Vorgang des vorangehenden Ersetzens der Bits.

6. Vorrichtung nach einem der vorhergehenden Ansprüche in Kombination mit Anspruch 2 oder 3, wobei jede Speicherzelle (Mi,j) einen ersten Zustand aufweist, in dem sie ein Bit speichert, das einen ersten logischen Wert aufweist, und einen zweiten Zustand, in dem sie ein Bit speichert, das einen zweiten logischen Wert 1 aufweist, und wobei das Referenz-Bit den zweiten logischen Wert aufweist.

7. Vorrichtung nach Anspruch 6, wobei der Zustandstransistor einer Speicherzelle (Mi,j) konfiguriert ist, um durchlässig zu sein, wenn die Speicherzelle in ihrem ersten Zustand ist, und blockiert zu sein, wenn die Speicherzelle in ihrem zweiten Zustand ist.

8. Vorrichtung nach Anspruch 7, wobei der Zustandstransistor vom Verarmungstyp ist und der Zustandstransistor, im ersten Zustand der Speicherzelle (Mi,j), eine Schwellenspannung aufweist, die negativ und niedriger als die Schwellenspannung des Zustandstransistors der Speicherzelle im jungfräulichen Zustand ist, während im zweiten Zustand der Speicherzelle die Schwellenspannung des Zustandstransistors positiv und höher als die Schwellenspannung des Zustandstransistors der Speicherzelle im jungfräulichen Zustand ist.

9. Vorrichtung nach Anspruch 8, wobei die Verarbeitungsmittel (MTR) konfiguriert sind, um eine Null-Lesespannung an das Steuer-Gate des Zustandstransistors einer Speicherzelle anzulegen, während eines Vorgangs der Lesung dieser Speicherzelle.

10. Vorrichtung nach Anspruch 8 oder 9, wobei der erste Zustand einer Speicherzelle (Mi,j) einem Löschzustand der Zelle entspricht und der erste logische Wert eine 1 ist, der zweite Zustand einer Speicherzelle einem Programmierzustand der Zelle entspricht und der zweite logische Wert eine 0 ist, und die Verarbeitungsmittel konfiguriert sind, um, damit sie ein bereits gelesenes Bit ersetzen, die zwei Speicherzellen, die dieses bereits gelesene Bit beinhalten, zu programmieren.

11. Vorrichtung nach Anspruch 10, wobei vorangehend zur Speicherung der Information im Speicherbereich (ZM) alle Speicherzellen (Mi,j) im Speicherbereich in einem Löschzustand sind.

12. Vorrichtung nach einem der vorhergehenden Ansprüche, die mehrere Speicherbereiche (ZM1-ZMK) umfasst, die dazu vorgesehen sind, dieselbe Information von N Bits zu beinhalten, und wobei die Verarbeitungsmittel konfiguriert sind, um sukzessive die verschiedenen Speicherbereiche zu lesen.

13. Verfahren, das eine Speicherung einer Information umfasst, die eine Folge von N Bits (D0-D31) in einer nichtflüchtigen Speichervorrichtung (DM) enthält, wobei die Vorrichtung eine Speicherebene (PM) umfasst, die mindestens einen Speicherbereich (ZM) enthält, der eine Speicherzellenmatrix (Mi,j) einschließt, die zwei Reihen und N Spalten aufweist, wobei jede Speicherzelle einen Zustandstransistor umfasst, der ein Steuer-Gate und ein Floating-Gate aufweist, die durch einen Transistor vertikaler Auswahl auswählbar sind, der in einem Substrat eingebettet ist und ein eingebettetes Auswahl-Gate enthält, wobei jede Speicherzellen-Spalte ein Paar Zwillings-Speicherzellen (Mi,j; Mi-1,j) einschließt, wobei die zwei Auswahltransistoren eines Paares von Zwillings-Speicherzellen ein gemeinsames Auswahl-Gate aufweisen, wobei die Speicherung der N Bits so ausgeführt wird, dass mit Ausnahme des letzten Bit der Folge ein aktuelles Bit der Folge in zwei Speicherzellen gespeichert wird, die sich in derselben Reihe und in zwei benachbarten Spalten befinden, und jeweils ein aktuelles Bit und das nächste Bit in zwei Zwillingszellen gespeichert werden.

14. Verfahren nach Anspruch 13, umfassend, um ein Bit lesen zu können, das in einer ersten Zwillingszelle (Mi,j) gespeichert ist, ein vorangehendes Ersetzen des Bit, das in der zweiten Zwillingszelle (Mi-1,j) gespeichert ist, durch ein Referenz-Bit, das einen Referenzwert aufweist, der ausgewählt ist, um eine korrekte Wiedergabe des Wertes des Bit zu ermöglichen, das in der ersten Zwillingszelle gespeichert ist.

15. Verfahren nach Anspruch 14, ferner ein sequentielles Lesen der N Bits (D0-D31) umfassend und ein Ersetzen eines bereits gelesenen aktuellen Bit der Folge durch das Referenz-Bit, bevor das nächste Bit der Folge gelesen werden kann.

16. Verfahren nach Anspruch 14 oder 15, ein Anlegen einer Null-Lesespannung an das Steuer-Gate des Zustandstransistors einer Speicherzelle (Mi,j) umfassend, während eines Vorgangs der Lesung dieser Speicherzelle.

17. Verfahren nach einem der Ansprüche 13 bis 16, eine individuelle Auswahl der zwei Bit-Linien umfassend, die den zwei Spalten zugeordnet sind, die sich an den zwei Enden des Speicherbereichs befinden, und eine gleichzeitige Auswahl von zwei benachbarten Bit-Linien (BLj; BLj+1), sowohl für den Vorgang der Speicherung der Information als auch für den Vorgang des vorangehenden Ersetzens der Bits.

18. Verfahren nach einem der Ansprüche 13 bis 17, wobei jede Speicherzelle (Mi,j) einen ersten Zustand besitzt, der einem Löschzustand der Zelle entspricht, in dem sie eine logische 1 speichert, und einen zweiten Zustand, der einem Programmierzustand der Zelle entspricht, in dem sie eine logische 0 speichert, und wobei das Verfahren umfasst, um ein bereits gelesenes Bit zu ersetzen, eine Programmierung der zwei Speicherzellen, die dieses bereits gelesene Bit beinhalten.

19. Verfahren nach Anspruch 18, vorangehend zur Speicherung der Information im Speicherbereich (ZM) umfassend, eine Löschung aller Speicherzellen im Speicherbereich.

20. Verfahren nach einem der Ansprüche 13 bis 19, eine Speicherung der Information in mehreren Speicherbereichen (ZM1-ZMK) umfassend und die sukzessive Lesung der verschiedenen Speicherbereiche.

## Claims

1. A non-volatile memory device, comprising a memory plane (PM) including at least one memory zone (ZM) including a matrix of memory cells (Mi,j) having two rows and N columns, each memory cell comprising a state transistor having a control gate and a floating gate, selectable by a vertical selection transistor buried in a substrate and including a buried selection gate, each column of memory cells including a pair of twin memory cells, the two selection transistors of a pair of twin memory cells having a common selection gate, and processing means (MTR) configured to store in the memory zone a piece of information (D0-D31) including a succession of N bits so that, with the exception of the last bit in the succession, a current bit in said succession is stored in two memory cells situated on the same row and on two adjacent columns and a current bit and the next bit are respectively stored in two twin cells.

2. The device according to claim 1, wherein the processing means (MTR) are configured to, in order to be able to read a bit stored in a first twin cell, replace beforehand the bit stored in the second twin cell with a reference bit having a reference value chosen to allow proper restitution of the value of the bit stored in the first twin cell.

3. The device according to claim 2, wherein the processing means (MTR) are further configured to read the N bits of the piece of information sequentially, to replace a current already read bit of said piece of information with the reference bit before being able to read the next bit in said succession.

4. The device according to one of claims 1 to 3, wherein the memory zone (ZM) includes a single bit line per column, connected to the drains of the state transistors of the pair of twin cells of the corresponding column, and a gate control line, per row of memory cells, connected to all the control gates of the state transistors of the memory cells of the corresponding row.

5. The device according to one of claims 1 to 4, wherein the processing means (MTR) comprise a column decoder (DECC) configured to individually select the two bit lines associated with the two columns situated at the two ends of the memory zone and to simultaneously select two adjacent bit lines (BLj; BLj+1), both for the information storage operation and for the operation of reading and replacing beforehand the bits.

6. The device according to one of the preceding claims taken in combination with claim 2 or 3, wherein each memory cell (Mi,j) has a first state in which it stores a bit having a first logic value and a second state in which it stores a bit having a second logic value 1, and the reference bit has the second logic value.

7. The device according to claim 6, wherein the state transistor of a memory cell (Mi,j) is configured to be on when the memory cell is in its first state and to be off when the memory cell is in its second state.

8. The device according to claim 7, wherein the state transistor is of the depletion type, and the state transistor has, in the first state of the memory cell (Mi,j), a threshold voltage that is negative and lower than the threshold voltage of the state transistor of the memory cell in the virgin state, whereas in the second state of the memory cell, the threshold voltage of the state transistor is positive and higher than the threshold voltage of the state transistor of the memory cell in the virgin state.

9. The device according to claim 8, wherein the processing means (MTR) are configured to apply a zero read voltage to the control gate of the state transistor of a memory cell during an operation of reading this memory cell.

10. The device according to claim 8 or 9, wherein the first state of a memory cell (Mi,j) corresponds to an erased state of the cell and the first logic value is 1, the second state of a memory cell corresponds to a programmed state of the cell and the second logic value is 0, and the processing means are configured to, in order to replace an already read bit, program the two memory cells containing this already read bit.

11. The device according to claim 10, wherein prior to storing the piece of information in the memory zone (ZM), all the memory cells (Mi,j) of the memory zone are in an erased state.

12. The device according to one of the preceding claims, comprising several memory zones (ZM1-ZMK) for containing the same piece of information of N bits, and the processing means are configured to successively read the different memory zones.

13. A method, comprising storing a piece of information including a succession of N bits (DO-D31) in a non-volatile memory device (DM), the device comprising a memory plane (PM) including at least one memory zone (ZM) including a matrix of memory cells (Mi,j) having two rows and N columns, each memory cell including a state transistor having a control gate and a floating gate, selectable by a vertical selection transistor buried in a substrate and including a buried selection gate, each column of memory cells including a pair of twin memory cells (Mi,j ; Mi-1,j), the two selection transistors of a pair of twin memory cells having a common selection gate, storing the N bits being carried out so that, with the exception of the last bit in the succession, a current bit in said succession is stored in two memory cells situated on a same row and on two adjacent columns and that a current bit and the next bit are respectively stored in two twin cells.

14. The method according to claim 13, comprising, in order to be able to read a bit stored in a first twin cell (Mi,j), replacing beforehand the bit stored in the second twin cell (Mi-1,j) with a reference bit having a reference value chosen to allow proper restitution of the value of the bit stored in the first twin cell.

15. The method according to claim 14, further comprising sequentially reading the N bits (DO-D31) and replacing a current already read bit in said succession with the reference bit before being able to read the next bit in said succession.

16. The method according to claim 14 or 15, comprising applying a zero read voltage to the control gate of the state transistor of a memory cell (Mi,j) during an operation of reading this memory cell.

17. The method according to one of claims 13 to 16, comprising individually selecting the two bit lines associated with the two columns situated at the two ends of the memory zone and simultaneously selecting two adjacent bit lines (BLj; BLj+1), both for the information storage operation and for the operation of reading and replacing beforehand the bits.

18. The method according to one of claims 13 to 17, wherein each memory cell (Mi,j) has a first state corresponding to an erased state of the cell in which it stores a logic 1, and a second state corresponding to a programmed state of the cell in which it stores a logic 0, and the method comprises, in order to replace an already read bit, programming the two memory cells containing this already read bit.

19. The method according to claim 18, comprising, prior to storing the piece of information in the memory zone (ZM), erasing all the memory cells of the memory zone.

20. The method according to one of claims 13 to 19, comprising storing of said piece of information in several memory zones (ZM1-ZMK), and successively reading the different memory zones.
